# EUROPEAN PATENT APPLICATION

(11) **EP 1 100 109 A1**
(43) Date of publication of application: **16.05.2001**
(21) Application number: 00124525.7
(22) Date of filing: 09.11.2000
(51) Int. Cl.: H01J 33/00, B05D 3/06

(54) **Electron beam irradiation processing method**

(30) Priority: 12.11.1999 JP 32287599
(71) Applicant: USHIODENKI KABUSHIKI KAISHA, Chiyoda-ku, Tokyo 100-0004 (JP)
(72) Inventor: Komori, Minoru, Kanagawa-ken, Yokohama-shi (JP)
(74) Representative: Tomerius, Isabel, Dr. Dipl.-Chem.

(57) **Abstract**

A process of irradiating high-energy electron beams on an item in cases when the distance between a vacuum tube type of electron beam tube and item is extended to permit processing of thick or large workpieces. In particular, electron beams are irradiated from an electron beam tube within a processing chamber by way of a window to subsequently irradiate an item, such as a resist or ink, that is applied to a workpiece. The atmosphere within the processing chamber contains a gas having a lower density than that of air, such as helium, a mixture of nitrogen and helium or neon. The distance traveled by the electron beams from the electron beam tube can be extended and the area reached by the electron beams can be expanded since the atmosphere within the processing chamber contains a gas having lower density than that of air.

## Description

### Background of the Invention

### Field of the Invention

The present invention relates to a method of processing objects. In particular, the invention concerns a method of processing objects using electron beam irradiation to bring about a chemical change in the irradiated object, for example curing resists which are coated on semiconductor wafers or drying ink which is coated on various types of printed material.

### Description of the Related Art

The use of electron beam irradiation to cure objects such as resists coated on semiconductor wafers, as well as dry/cure coatings, inks, adhesives, protective resins applied to substrates is conventional within the art. To carry out such an operation, generally two types of electron beam tubes have been used: an electrolytic discharge type tube and a thermion discharge type tube. In each of the aforementioned devices, a chamber is provided with an electron beam source fitted with a cathode and anode, and the object to be irradiated is disposed within said chamber.

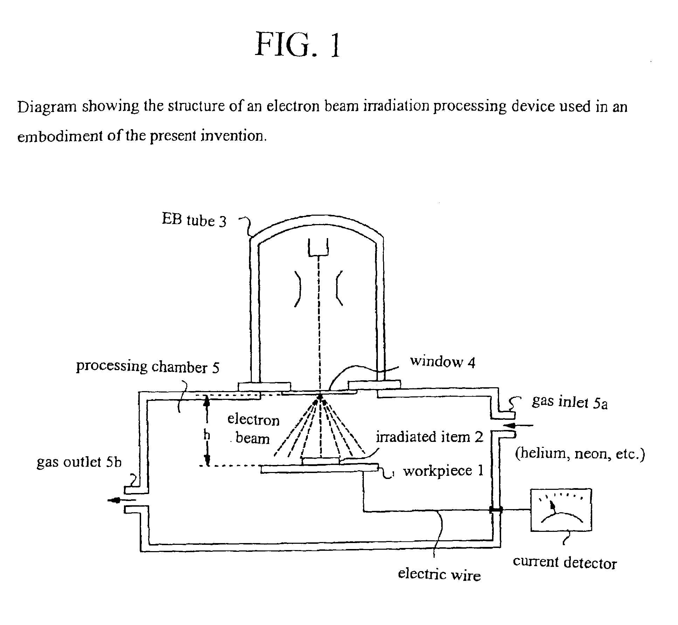

Figure 1 illustrates an example of an electrolytic discharge type of electron beam tube (EB tube) as taught in Japanese Kokai Publication Hei-11-506670 and corresponding Published International Application W096-36070. In this type of device, the electrolytic discharge type of electron beam tube requires that a high vacuum be established within the chamber in which the object is disposed.

Accordingly, a vacuum tube type of EB tube having a window has been disclosed in Japanese Kokai Publication Hei-10-512092 and corresponding U.S. Patent No. 5,612,588. In this device, the EB tube includes a thermion radiator and an electron beam accelerator installed within a vacuum container having an electron-beam permeable window. Thermions emitted from the thermion radiator are accelerated by the electron beam accelerator which are then radiated through the permeable window. Electron beams can be extracted from the window of the electron beam tube in normal-pressure air when using such an electron beam tube. For this reason, depressurization of the atmosphere in which an object is disposed is unnecessary, which renders a vacuum pump and vacuum chamber for depressurization unnecessary, thereby simplifying the structure and handling of an electron beam irradiation processing device.

### Summary of the Invention

It is an object of the present invention to provide a method of processing an object using light irradiation from electron beams for instances in which the distance between an electron-beam permeable window located in a processing chamber and the object to be irradiated is large.

It is a further object of the present invention to provide a method of processing an object using light irradiation from electron beams that are dispersed over a broad area of an object for instances in which the distance between the electron-beam permeable window and the object to be irradiated is large.

Still yet another object of the present invention is to provide a method of processing an object using light irradiation from electron beams whereby the range of electron beam irradiation is uniform in the thickness direction of the object to be irradiated for instances in which the distance between the electron-beam permeable window and the object to be irradiated is large.

The present invention was devised in light of aforementioned circumstances. In particular, the purpose of the present invention is to provide an electron beam irradiation processing method capable of processing thick or large objects or workpieces so that the high-energy electron beams may irradiate the item even in circumstances in which the distance between the EB tube and the object or workpiece is large.

Accordingly, to resolve the aforementioned problems, the present method provides a gas within the processing chamber in which an irradiated item is placed, the gas having a lower density than that of air. By so doing, the distance reached by the electron beams irradiated from the EB beam tube can be extended, meaning, the range in which the irradiated beams travel can be expanded greater distances than in conventional devices. As a result, enhanced irradiation of objects or workpieces having increased thicknesses or those objects or workpieces that are solid can be achieved using the present invention.

The aforementioned experiments confirmed that the distance over which electron beams extend when irradiated from an EB tube could be prolonged and the irradiation range could be expanded by using helium, a mixed gas comprising 50% nitrogen and helium, or neon instead of air (nitrogen) as the atmosphere in processing chamber 5.

The density of air is about 1.28 g/l, the density of nitrogen is 1.25 g/l while the density of helium is 0.179 g/l, the density of mixed gas comprising 50% nitrogen and helium is about 0.71 g/l, and the density of neon is 0.90 g/l. Since the density of the atmosphere (gas) through which electron beams pass is lower when using the substitute gases, the probability of a collision between electron beams and atmospheric particles decreases, thereby increasing the distance and area over which electron beams can travel. Furthermore, increased electron beam energy can be maintained even if the distance between an EB tube and an irradiated item is extended since the probability of a collision between electron beams and atmospheric particles decreases. Accordingly, many electron beams capable of transit are available even if an energy barrier such as polyimide foil is present.

The use of helium, mixed gas comprising 50% nitrogen and helium, and neon when the gas in processing chamber 5 is nitrogen was presented here, but the same effects would be realized even if other mixed gases such as neon and nitrogen or gases having lower density than air such as hydrogen, methane or mixtures with nitrogen were used.

In the following, the invention is specifically described using embodiments illustrated in the drawings.

### Brief Description of The Drawings

Figure 1 is a diagram illustrating the structure of an electron beam irradiation processing device used in an embodiment of the present invention;
Figure 2 is a diagram illustrating the irradiation distribution characteristics of an EB tube in a nitrogen atmosphere;
Figure 3 is a diagram illustrating the cumulative current relative to a distance h in helium, helium mixed gas, neon and nitrogen atmospheres;
Figure 4 is a diagram illustrating the half band-width relative to distance h in helium, helium mixed gas, neon and nitrogen atmospheres;
Figure 5 is a diagram illustrating the half band-width relative to a distance h in the presence/absence of polyimide foil in helium and nitrogen atmospheres; and
Figure 6 is a diagram illustrating a diagrammatic cross-sectional view of an electron beam irradiation processing device that irradiates an item using a vacuum tube type of electron beam tube used in another embodiment of the present invention.

### Detailed Description of The Invention

Figure 1 contains a diagram that illustrates the structure of an electron beam irradiation processing device used in an exemplary embodiment of the present invention. In Figure 1, reference number 1 denotes a workpiece such as a wafer or substrate in which an item 2, such as a resist or ink is coated. Reference number 3 denotes an EB tube used for dispersing the radiation while reference number 4 denotes a permeable window through which electron beams are radiated. Reference number 5 denotes a processing chamber having a gas inlet 5a for injecting a gas or gas mixture and also including a gas outlet 5b. A gas having lower density than air (nitrogen), for example helium, neon, or mixed gases thereof, is inducted into processing chamber 5 via the gas inlet 5a and gas within processing chamber 5 is discharged through gas outlet 5b. In the present embodiment, a window cooling means may be installed adjacent to the window 4 to prevent the window from being overheated during operation.

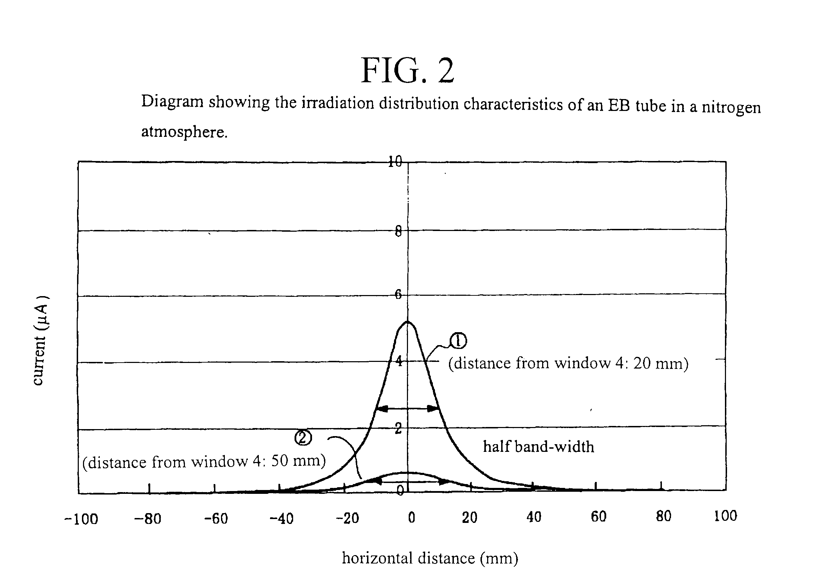

Figures 2 through Figures 5 contain diagrams of experimental data derived from the present invention. During the experiment, nitrogen, helium, or a mixed gas comprising 50% nitrogen and 50% helium (hereinafter abbreviated 50% helium) was injected into processing chamber 5 from gas inlet 5a using the device illustrated in Figure 1. In this experiment, an uncoated Smm square aluminum plate served as the workpiece 1. A measurement of the current flowing through the aluminum plate while under irradiation by electron beams from EB tube 3 was obtained while the aluminum plate 1 rested at a position separated by distance h from window 4 and moved in the horizontal direction (left-right direction as illustrated in Figure 1). In an effort to enhance the accuracy of the current reading, an electric wire was attached at one end to the aluminum plate 1 and at the opposite end to a current detector positioned outside of processing chamber 5. Current was generated when the aluminum plate 1 was irradiated with electron beams, with the current being subsequently detected and measured by the current detector. The cumulative value of the current corresponds to the amount of electron beam irradiation.

Figure 2 shows the results of measuring the current flowing through a 5mm square aluminum plate when using a single EB tube to which 50kV voltage is applied (200 µA current) in a normal pressure nitrogen atmosphere at distances of h = 20mm and h = 50mm. In this experiment, each of the aforementioned gases was inducted into processing chamber 5 and the curve of change in the current relative to several distances h was measured, after which the cumulative current was determined, as illustrated in Figure 2.

The amount of electron beam irradiation at distance h was defined based on the magnitude of this cumulative current. It would be ideal for the cumulative current to remain unchanged (constant) even if distance h were increased. Horizontal direction 0 represents a position directly below the center of the window of EB tube 3. In addition, reference point 1 in the diagram represents the current at distance h = 20mm while reference point 2 represents the current at h = 50mm. The half band-width (width of the curve of change at P/2 when P represents the peak value of the curve of change) was determined from the curve of change in the current, and was defined as the area irradiated by electron beams with this half band-width. The shapes of the curve of change of the current are assumed to match at a given half band-width. Increase in the half band-width and an increase in distance h is considered to be ideal.

A workpiece of an aluminum plate covered with 7.5µm polyimide foil and an uncovered workpiece were also used to examine the uniformity of the range of electron beam irradiation in the thickness direction of an item, and the half band-width of the current was examined. A workpiece coated with polyimide foil served as the item 2 to be irradiated. The half band-width of the current was determined and subsequently compared with the half band-width of a workpiece without polyimide foil. The uniformity of the range of electron beam irradiation in the thickness direction of an irradiated item was defined through the difference between the half band-widths with and without the polyimide foil. The range of electron beam irradiation would be consistent on the top and bottom of an irradiated item if the half band-widths are virtually consistent with or without polyimide foil. Accordingly, that would signify the ability to uniformly process the irradiated item 2 in the thickness direction. However, if the half band-width in the presence of polyimide foil is smaller than the half band-width in the absence of polyimide foil, the range of electron beam irradiation at the bottom of an irradiated item would be narrower than that at the top, which would mean that processing of uneven in the thickness direction of an irradiated item. That is the cause of poor processing. Virtual consistency of the half band-widths in the presence/absence of polyimide foil even at great distances would be ideal. Energy in excess of 20 kV is understood to be required for electron beams to reach said polyimide foil. Accordingly, narrowing of the half band-width upon permeation of polyimide foil indicates a decrease in energy of electron beams irradiated on an irradiated item.

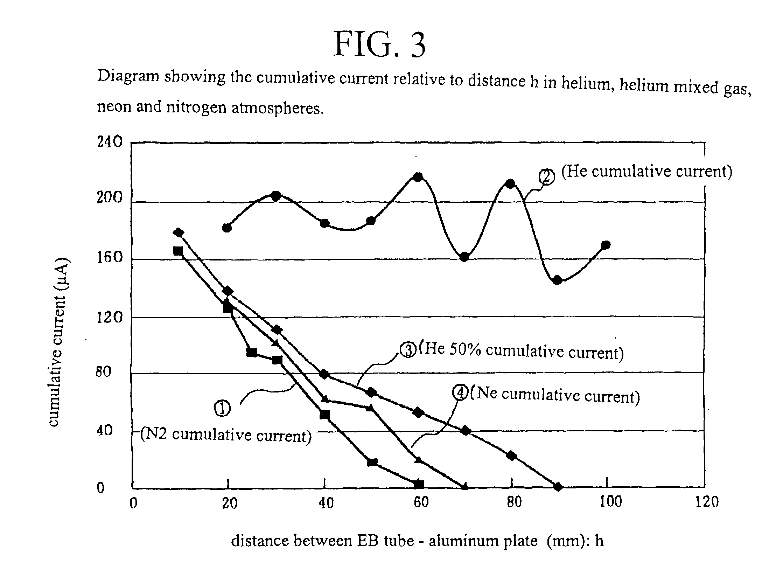

As illustrated in Figure 3, and based upon the aforementioned assumptions, the gas within processing chamber 5 was altered and the cumulative current relative to aforementioned distance h, the half band-width of the current curve relative to distance h as well as the half band-width of the current curve were measured independently of polyimide foil relative to distance h. The pressure was at atmospheric pressure. First, the cumulative current was examined relative to aforementioned distance h using an aluminum plate without polyimide foil. In Figure 3, the abscissa represents the distance h [mm] from the window of EB tube 3 to the aluminum plate while the ordinate represents aforementioned cumulative current [µA]. Figure 3 further shows the case when using a 5mm square aluminum plate in which 50 kV of voltage was applied to said EB tube 3 (200 µA current) using one EB tube 3.

Reference point 1 in Figure 3 represents the case of a normal pressure nitrogen atmosphere while reference point 2 represents the case of a helium atmosphere. The cumulative current gradually decreases in a normal pressure nitrogen atmosphere as distance h increases, and it becomes virtually zero at distance h = 50 mm. The cumulative current fluctuates but undergoes virtually no decrease in a helium atmosphere if the range of distance h is under 100 mm, but current was detected even at distance h above 100 mm. Specifically, adequate electron beam irradiation would be realized even with increase in distance h (mm).

Reference point 3 represents the case of a 50 % helium atmosphere. The cumulative current decreases with increase in distance h (mm) in a 50 % helium atmosphere, but the distance h (mm) at which the current reaches zero is 90 mm, which is 30 mm greater than in a nitrogen atmosphere. Reference point 4 represents a neon atmosphere. The effects in a neon atmosphere are less than in a helium atmosphere, but the distance h at which the current reaches zero is 70 mm, which is 10 mm greater than in a nitrogen atmosphere.

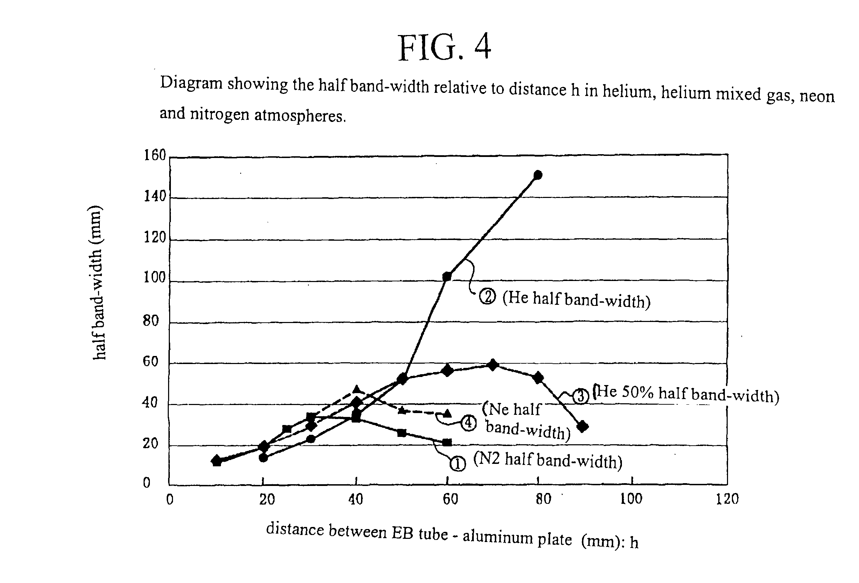

Figure 4 is a diagram illustrating the half band-width relative to distance h (mm) using aluminum plate without polyimide foil. The abscissa in Figure 4 represents the distance h (mm) while the vertical ordinate represents the half band-width (mm). As in the prior examples, 50 kV of voltage was applied to a 5 mm square aluminum plate using a single EB tube 3 (200 µA current). Reference point 1 represents the case in which a nitrogen atmosphere was used in the processing chamber. The half band-width of the current gradually narrowed to a peak at distance h = 30 mm in a nitrogen atmosphere. Reference point 2 represents the case of a helium atmosphere. The half band-width increased with increase of the distance in a helium atmosphere. Specifically, electron beam irradiation could be carried out over a broad range even at great distance h.

Reference point 3 represents the case of a 50 % helium atmosphere. The half band-width increases up to distance h = 70 mm and decreases thereafter in a 50 % helium atmosphere. However, a half band-width approaching the maximum half band-width found in a nitrogen atmosphere was present even at distance h = 90 mm. Reference point 4 represents a neon atmosphere. The effects in a neon atmosphere were less compared to helium, but the half band-width was greater than that in a nitrogen atmosphere even with increase in distance h.

A plurality of EB tubes are aligned and disposed to uniformly irradiate electron beams when processing the entire surface of a workpiece 1 having a broad area. Empirically, the separation of the EB tubes should be commensurate with aforementioned half band-width, but setting a somewhat narrower separation would be appropriate. Specifically, a large number of EB tubes would be necessary to irradiate a given area if the half band-width is narrower. Furthermore, the guaranteed lifetime of EB tubes is determined relative to the duration of use (duration of electron beam irradiation). When using a plurality of EB tubes, those EB tubes must be maintained so as to remain within the guaranteed lifetime. Accordingly, an increased number of EB tubes would have to be used as the half band-width becomes narrower, and that would raise the running costs.

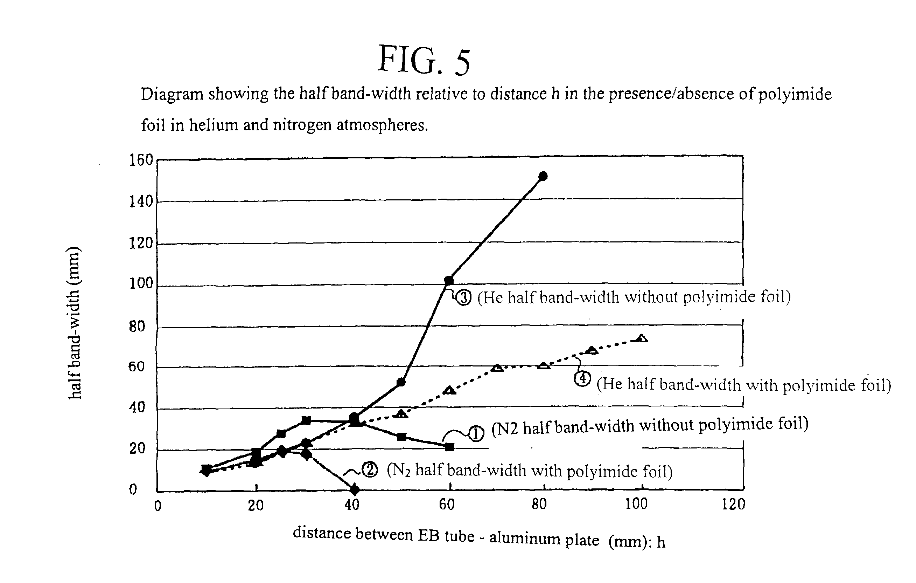

Figure 5 is a diagram illustrating the results of cases in which the disposed separation of EB tubes broaden as the half band-width expands. In this instance, the running costs could be lowered and the number of EB tubes reduced for a prescribed area. The half band-widths relative to distance h were examined using aluminum plates without polyimide foil and aluminum plates covered with polyimide foil. The abscissa in Figure 5 represents distance h (mm) while the ordinate represents half band-width (mm). As in the other experiments, 50 kV of voltage was applied to one EB tube 3 (200 µA current) and a 5 mm square aluminum plate was used. In addition, the thickness of the polyimide foil was 7.5 µm.

Reference point 1 represents the half band-width in a nitrogen atmosphere when polyimide foil was omitted while reference point 2 represents the half band-width in a nitrogen atmosphere when using polyimide foil. Comparing reference point 1 with reference point 2 shows that the half band-widths were consistent independent of the presence of polyimide foil up to distance h = 20 mm. However, reference point 2 became smaller than reference point 1 when distance h exceeded 20 mm, and the half band-width became virtually zero for reference point 2 at h = 40 mm. Specifically, the range of electron beam irradiation on the top and bottom of an irradiated item differed in a nitrogen atmosphere. In particular. the top of an irradiated item was processed by electron beam irradiation at distance h = 40 mm, but electron beams did not reach the bottom and it could not be processed.

Furthermore, reference point 3 shows the half band-width in a helium atmosphere without polyimide foil while reference point 4 shows the half band-width in a helium atmosphere with polyimide foil. Comparison of reference point 3 with reference point 4 shows consistency of half band-widths independently of the presence of polyimide foil up to distance h = 40 mm. Specifically, a uniform range of electron beam irradiation could be attained in the thickness direction of an irradiated item even at great distance h compared to a nitrogen atmosphere. Furthermore, the half band-width did not reach zero even at great distance h in a helium atmosphere if polyimide foil was present. This means that the bottom of an irradiated item is also processed (electron beams reach the bottom) if the atmosphere is helium.

A longer distance h at which the half band-widths are consistent in the presence and absence of polyimide foil permits use of a longer distance between an EB tube and the irradiation surface of an irradiated item. Accordingly, it would be useful in maintaining the space for disposition of a workpiece. Furthermore, a thicker (corresponding to higher electron energy) irradiated item could be processed uniformly in the thickness direction at a given distance h.

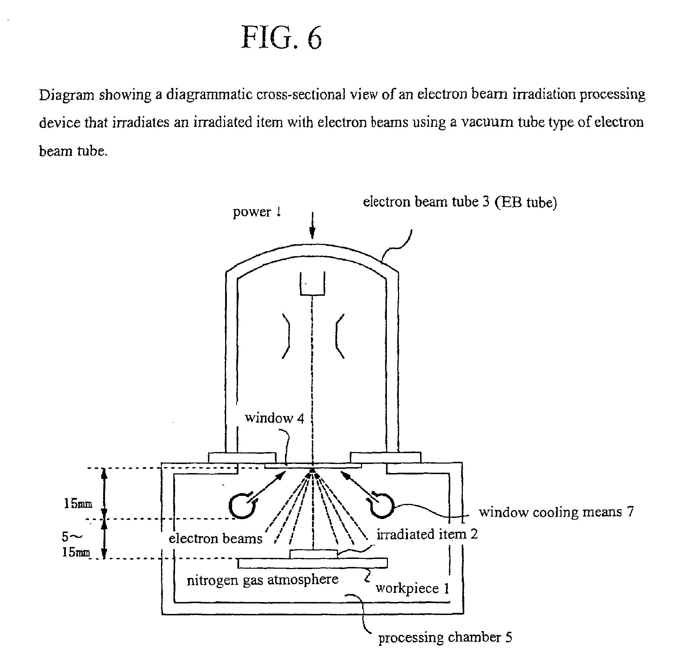

Figure 6 illustrates a diagrammatic cross-sectional view of another embodiment of an electron beam irradiation processing device that can be used for the aforementioned method. This electron beam irradiation processing device irradiates an item 2 such as a resist or ink supported on a workpiece 1 such as a wafer or substrate using electron beams emitted from a vacuum tube type of EB tube 3, and further includes an electron-beam permeable window 4 in which electron beams are radiated. Workpiece 1 is placed in processing chamber 5 at normal pressure or in a nitrogen atmosphere. The nitrogen density is 1.25 g/l while the density of air is 1.28 g/l. Since the densities of the two do not differ significantly, the nitrogen atmosphere is treated here as being equal to that of an air atmosphere. Electron beams are created in EB tube 3 and are output through window 4. Window cooling means 7 is installed adjacent window 4 for preventing overheating of the window 4 when EB tube 3 emits the electron beams. The cooling means sends cooling air toward window 4 in an effort to cool window 4. A space of 15 mm to 30 mm is created between EB tube 3 and irradiated item 2 to install window-cooling means.

The ability to conduct electron beam irradiation processing even when there is a great distance between window 4 of EB tube 3 and workpiece 1 is desirable when considering the ease of conveyance of workpiece 1 to an electron beam irradiation processing chamber as well as the ability to process solid or thick workpieces 1. Specifically, it would be desirable for electron beam irradiation processing to satisfy the following conditions.

The following effects can be attained in the present invention as explained above. The distance over which electron beams irradiated from an EB tube extend can be prolonged and the range that is covered (h = half band-width) can be expanded by using an atmosphere such as helium or neon whose density is lower than that of air (nitrogen) in the processing chamber when irradiating an irradiated item with electron beams. Accordingly, processing would be possible with increased distance from an irradiated item, with a thicker workpiece and with solid pieces even if a means of cooling the window of an EB tube were installed between an EB tube and an irradiated item.

Second, the range over which electron beams travel could be expanded. For this reason, the number of EB tubes could be reduced when disposing a plurality of EB tubes to uniformly irradiate electron beams over a broad area. Accordingly, the trouble of maintenance to ensure that EB tubes remain within the guaranteed lifetime could be reduced and the running cost could be lowered. Third, the range over which electron beams irradiate the top of an irradiated item and the range over which electron beams irradiate the bottom of an irradiated item could be equalized even if the distance between an EB tube and a given irradiated item were to be extended. As a result, adequate space could be taken between an EB tube and an irradiated item and even a thick irradiated item could be uniformly processed in the thickness direction at a given distance.

While the present invention has been illustrated and described in connection with what is considered the most practical and preferred embodiments, it is understood that this invention is not limited to the embodiments disclosed herein but is intended to cover various arrangements included within the spirit and scope of the broadest reasonable interpretations and equivalent arrangements.

## Claims

1. A method of irradiating an object using an electron beam irradiation processing device having a processing chamber including a gas inlet and gas outlet, a vacuum type electron beam tube for emitting electron beams, an electron beam permeable window positioned between said vacuum tube and said object, said method comprising the steps of:
placing the object within said processing chamber at a certain distance from said electron beam permeable window;
discharging a gas having a lower density than air into said processing chamber through said gas inlet, said gas extending the distance traveled by the electron beams inside said processing chamber;
irradiating the object with electron beams from said vacuum type electron beam tube.

2. The method according to claim 1, wherein the gas comprises helium.

3. The method according to claim 1, wherein the gas comprises neon.

4. The method according to claim 1, wherein the gas comprises at least one of hydrogen and methane.

5. The method according to claim 1, wherein the gas comprises a mixture of 50% nitrogen and 50 % helium.
